# EUROPÄISCHE PATENTANMELDUNG

(11) **EP 2 963 753 A1**
(43) Veröffentlichungstag der Anmeldung: **06.01.2016**
(21) Anmeldenummer: 15160723.1
(22) Anmeldetag: 25.03.2015
(51) Int. Cl.: H02H 3/33, G01R 31/02, H02H 3/05, H02H 3/347

(54) **FEHLERSTROMSCHUTZVORRICHTUNG MIT NETZSPANNUNGSABHÄNGIGER UND NETZSPANNUNGSUNABHÄNGIGER ERFASSUNG**

(30) Priorität: 04.07.2014 DE 102014213054; 24.10.2014 DE 102014221720
(71) Anmelder: Siemens Aktiengesellschaft, 80333 München (DE)
(72) Erfinder: Adlhoch, Manfred, 93170 Bernhardswald (DE)

(57) **Zusammenfassung**

Es soll eine allstromsensitive Fehlerstromschutzvorrichtung mit einfachem Aufbau bereitgestellt werden. Dazu wird vorgeschlagen, dass eine netzspannungsunabhängige Erfassungsschaltung (25) durch eine netzspannungsabhängige zweite Erfassungsschaltung (28) ergänzt wird, wobei beide Erfassungsschaltungen an den gleichen Summenstromwandler (22) angeschlossen sind. Eine Umschalteinrichtung (27) schaltet eine der beiden Erfassungsschaltungen an den Summenstromwandler (22).

## Beschreibung

Die vorliegende Erfindung betrifft eine Fehlerstromschutzvorrichtung zum Überwachen eines Netzes mit einem Gehäuse, einem Summenstromwandler in dem Gehäuse zur Lieferung eines Summenstroms von dem Netz, einer spannungsunabhängigen ersten Erfassungsschaltung, die in das Gehäuse eingebaut ist, zur Erfassung des Summenstroms und einer Auslöseeinrichtung, die ebenfalls in das Gehäuse eingebaut und von der ersten Erfassungsschaltung angesteuert ist.

Fehlerstrom-(FI)Schutzvorrichtungen (auch Fehlerstromschutzschalter genannt) dienen in Verbraucheranlagen zum Personen- und Brandschutz. Fehlerstromschutzschalter gegen Erdfehlerströme bzw. technische Ableitströme, auch RCD (Residual Current Device) genannt, sind Schutzschaltgeräte, die den elektrischen Stromkreis überwachen, um elektrische Fehler (Installationsfehler bzw. Schutz bei direktem Berühren) in Installationen zu detektieren und abzuschalten.

Da unterschiedliche Fehlerströme (Gleichströme und Wechselströme aller Art) von Fehlerstromschutzschaltern erfasst werden sollen, unterscheidet man unterschiedliche Typen von Fehlerstromschutzschaltern. So dienen Fehlerstromschutzschalter bzw. Fehlerstromschutzvorrichtungen vom Typ AC lediglich zur Erfassung von sinusförmigen Wechselfehlerströmen. Fehlerstromschutzvorrichtungen vom Typ A erfassen neben sinusförmigen Wechselfehlerströmen auch pulsierende Gleichfehlerströme. Darüber hinaus erfassen Fehlerstromschutzvorrichtungen vom Typ F zusätzlich Fehlerströme, die aus einem Frequenzgemisch von Frequenzen bis 1 kHz bestehen. Schließlich dienen Fehlerstromschutzvorrichtungen vom Typ B neben der Erfassung der Fehlerstromformen des Typs F auch zur Erfassung von glatten Gleichfehlerströmen, d.h. sie sind allstromsensitiv. Die Erfassung von Gleichfehlerströmen erfordert in der Regel einen zusätzlichen Summenstromwandler und eine Elektronikeinheit, welche eine separate Stromversorgung benötigt. Daher sind Fehlerstromschutzschalter vom Typ B netzspannungsabhängig.

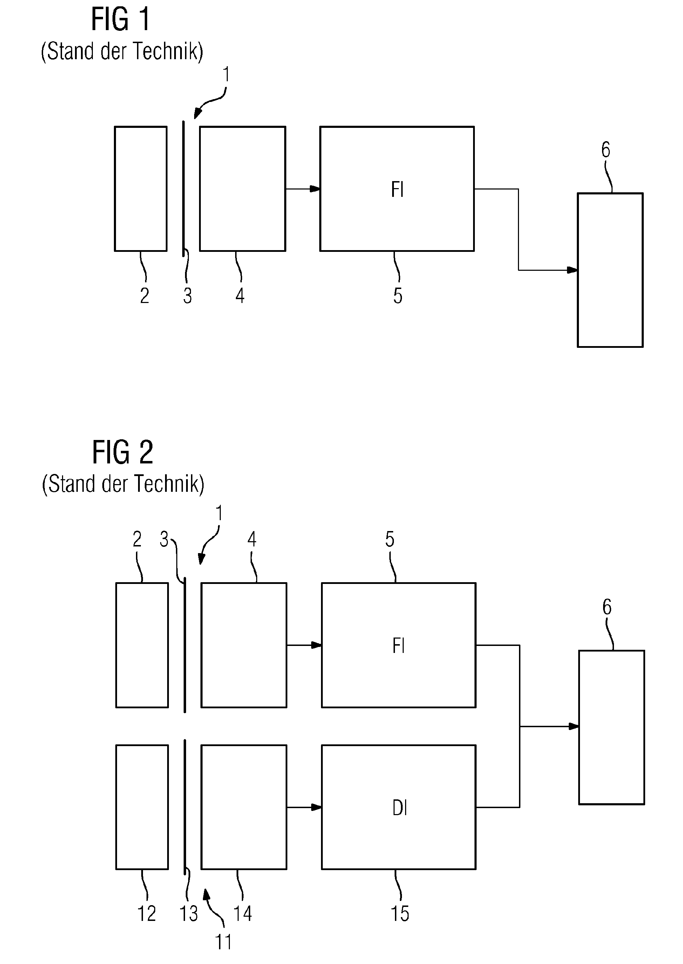

Netzspannungsunabhängige Fehlerstromschutzschalter beispielsweise vom Typ A oder F besitzen den prinzipiellen Aufbau gemäß FIG 1. Ein netzspannungsunabhängiger Summenstromwandler 1 erfasst einen Summenstrom von mehreren Leitungen (z. B. Phasenleitungen L1, L2, L3 und Nullleitung N in einem Dreiphasensystem), welche die Primärseite 2 des Summenstromwandlers 1 bilden. Ein typischerweise ringförmiger Kern ist in FIG 1 als linienförmiger Wandlerkern 3 symbolisiert. Die Sekundärseite 4 des Summenstromwandlers 1 wird üblicherweise von einer Spule um den ringförmigen Wandlerkern 3 gebildet. Das Ausgangssignal der Sekundärseite 4 repräsentiert den Summenstrom und wird einer Auslöserschaltung bzw. Erfassungsschaltung 5 zugeführt. Diese wird meist durch eine Flachbaugruppe gebildet. Die Erfassungsschaltung 5 erfasst eine Amplitude des Wechselstroms und produziert ein Auslösesignal, wenn die Wechselstromamplitude eine Bemessungsstromgrenze überschreitet. Mit dem Ausgangssignal der Erfassungsschaltung 5 wird ein Haltemagnet bzw. eine Auslöseeinrichtung 5 gesteuert. Diese Auslöseeinrichtung 6 unterbricht im Auslösefall, d.h. bei zu hohem Summenstrom, die stromführenden Netzleitungen.

Derartige netzspannungsunabhängige Fehlerstromschutzschalter besitzen jedoch zwei gravierende Schwachpunkte. Zum einen kann ein Drahtbruch des Summenstromwandlers 1 zur Erfassungsschaltung 5 bzw. ein Drahtbruch von der Erfassungsschaltung 5 zur Auslöseeinrichtung 6 nicht erkannt werden. Bei einem solchen Drahtbruch wird die Fehlerstromschutzvorrichtung unabhängig vom Summenstrom nicht ausgelöst. Die Folge ist ein sogenannter "Auslöseversager".

Ein zweiter Schwachpunkt stellt ein primärseitiger Gleichfehlerstrom dar, welcher den Summenstromwandler in die Sättigung treibt. Ist der Gleichfehlerstrom einem Wechselfehlerstrom überlagert, so wird der Wechselfehlerstrom wegen der Sättigung des Wandlerkerns 3 nicht mehr oder nicht ausreichend auf die Sekundärseite übertragen. Die Folge ist wiederum ein "Auslöseversager".

Da Fehlerstromschutzschalter in der Regel auch über Prüftasten mit einem Prüfstromkreis, welcher einen klein dimensionierten Widerstand aufweist, verfügen, besteht außerdem die Gefahr, dass dieser Widerstand aufgrund des anhaltenden Gleichstroms zerstört wird.

Der erstgenannte Schwachpunkt bezüglich des Drahtbruchs kann beispielsweise durch hohe Fertigungsqualität bezüglich der Drähte bzw. Lötstellen gelöst werden. Alternativ können auch redundante Funktionsbaugruppen verwendet werden. Eine Lösung bezüglich des überlagerten Gleichfehlerstroms besteht darin, einen sogenannten allstromsensitiven Fehlerstromschutzschalter, z. B. FI Typ B, zu verwenden.

Ein Prinzipschaltbild eines klassischen netzspannungsabhängigen Fehlerstromschutzschalters Typ B ist in FIG 2 wiedergegeben. Der obere Teil der Schaltung mit dem ersten Summenstromwandler 1, der daran angeschlossenen ersten Erfassungsschaltung 5 und der Auslöseeinrichtung 6 entspricht dem Aufbau von FIG 1. Die Komponenten 1 bis 5 werden auch als FI-Teil bezeichnet.

Parallel zu diesem netzspannungsunabhängigen FI-Teil besitzt der Fehlerstromschutzschalter Typ B einen netzspannungsabhängigen DI-Teil (Differenzstrom). Dieser umfasst einen netzspannungsabhängigen Summenstromwandler 11 mit Primärseite 12, Summenstromwandlerkern 13 und Sekundärseite 14. Die Sekundärseite 14 wird mit Pulsen erregt, die von einer nicht näher dargestellten Elektronik erzeugt werden. Dazu ist eine entsprechende Netzspannungsversorgung notwendig. Dem Sekundärteil 14 schließt sich signaltechnisch eine zweite Erfassungsschaltung 15 an, welche typischerweise digital ausgeführt ist. Sie dient dazu, aus dem Signal des zweiten Summenstromwandlers 11 einen Gleichfehlerstrom zu erkennen und ein entsprechendes Auslösesignal an die Auslöseeinrichtung 6 zu senden. Der Fehlerstromschutzschalter ist damit in der Lage nicht nur einen Wechselfehlerstrom, sondern auch einen Gleichfehlerstrom zu erkennen und für eine entsprechende Unterbrechung zu sorgen.

Die Aufgabe der vorliegenden Erfindung besteht somit darin, mit einfacheren Mitteln eine allstromsensitive Fehlerstromschutzvorrichtung bereitzustellen.

Erfindungsgemäß wird diese Aufgabe gelöst durch eine Fehlerstromschutzvorrichtung zum Überwachen eines Netzes mit
- einem Gehäuse,
- einem einzigen Summenstromwandler in dem Gehäuse zur Lieferung eines Summenstroms von dem Netz,
- einer netzspannungsunabhängigen ersten Erfassungsschaltung, die in das Gehäuse eingebaut ist, zur Erfassung des Summenstroms und
- einer Auslöseeinrichtung, die ebenfalls in das Gehäuse eingebaut und von der ersten Erfassungsschaltung angesteuert ist,
   wobei
- eine in das Gehäuse eingebaute, netzspannungsabhängige, zweite Erfassungsschaltung an den Summenstromwandler angeschlossen ist,
- die zweite Erfassungsschaltung von einem in das Gehäuse eingebauten Netzteil mit Energie versorgbar ist,
- die zweite Erfassungsschaltung dazu ausgebildet ist, eine Impedanz an einer Sekundärspule des Summenstromwandlers zu messen und die Auslöseeinrichtung in Abhängigkeit von dem Messergebnis anzusteuern, und
- eine Umschalteinrichtung in dem Gehäuse dazu ausgebildet ist, die beiden Erfassungsschaltungen wechselweise an den Summenstromwandler zu schalten.

In vorteilhafter Weise besitzt die Fehlerstromschutzvorrichtung also nur einen einzigen Summenstromwandler. Dieser wird von der netzspannungsunabhängigen als auch von der netzspannungsabhängigen Erfassungsschaltung als Lieferant des Summenstroms benutzt. Eine Umschalteinrichtung, die ebenfalls in das Gehäuse der Fehlerstromschutzvorrichtung eingebaut ist, schaltet wechselweise die beiden Erfassungsschaltungen an den Summenstromwandler. Damit ist es möglich, dass der gleiche Summenstromwandler zeitweise zur Erfassung von Wechselstromkomponenten durch die netzspannungsunabhängige erste Erfassungsschaltung und zeitweise zur Erfassung von Gleichstromkomponenten des Summenstroms durch die netzspannungsabhängige zweite Erfassungsschaltung genutzt wird.

Vorzugsweise ist die erste Erfassungsschaltung ausschließlich zur Erfassung von Wechselstromkomponenten des Summenstroms ausgebildet. Dies hat den Vorteil, dass der Summenstromwandler einfach nach dem Prinzip eines Transformators aufgebaut werden kann und daher keine netzspannungsabhängige Elektronik notwendig ist. In einer Ausführungsvariante ist die zweite Erfassungsschaltung zur Erfassung von Gleichstromkomponenten und Wechselstromkomponenten des Summenstroms ausgebildet. Wenn dann die erste Erfassungsschaltung Wechselstromkomponenten des Summenstroms erfasst, kann sich eine Überlappung der Erfassungsbereiche bei den Wechselstromkomponenten ergeben. Erfasst die erste Erfassungsschaltung beispielsweise Wechselstromfrequenzen bis 100 kHz und die zweite Erfassungsschaltung Wechselströme bis 1 kHz, so erfolgt in diesem niedrigen Frequenzbereich bis 1 kHz eine doppelte Erfassung. Durch diese Redundanz kann die Sicherheit einer Fehlerstromschutzvorrichtung erhöht werden.

Bei einer alternativen Ausführungsform kann die zweite Erfassungsschaltung ausschließlich zur Erfassung von Gleichstromkomponenten des Summenstroms ausgebildet sein. Da also keine Wechselstromkomponenten von der zweiten Erfassungsschaltung detektiert werden müssen, kann diese wesentlich einfacher ausgestaltet werden als für den Fall einer DC- und AC-Erfassung.

In einer besonders vereinfachten Ausführungsform ist die zweite Erfassungsschaltung dazu ausgebildet, aus einer erfassten Gleichstromkomponente allein durch eine Schwellwertfunktion ein Ansteuersignal für die Auslöseeinrichtung zu erzeugen. Eine Schwellwertfunktion ist schaltungstechnisch mit minimalem Aufwand zu realisieren. Dies bedeutet, dass eine allstromsensitive Fehlerstromschutzvorrichtung, die also Gleich- und Wechselströme detektiert, mit den beiden parallelen Erfassungsschaltungen sehr einfach aufgebaut werden kann, da die Gleichstromerfassung mit einer einfachen Schwellwerterkennung realisiert ist.

Darüber hinaus kann die Fehlerstromschutzvorrichtung eine Statusanzeige aufweisen, mit der ein Repräsentant des Messergebnisses der zweiten Erfassungsschaltung anzeigbar ist. In vorteilhafter Weise ist es damit möglich, nach außen zu signalisieren, was zum Auslösen der Auslöseeinrichtung geführt hat. So kann die Statusanzeige beispielsweise als einfache LED ausgeführt werden, die anzeigt, dass die zweite Erfassungsschaltung und nicht die erste Erfassungsschaltung zum Auslösen geführt hat. Im einfachsten Fall kann die Statusanzeige auch darauf beschränkt sein, nur das Erkennen einer Gleichstromkomponente in dem Summenstrom durch Leuchten anzuzeigen. Falls die Fehlerstromschutzvorrichtung dann ausgelöst wurde und die Statusanzeige nicht leuchtet, kann davon ausgegangen werden, dass eine Wechselstromkomponente zum Auslösen geführt hat. Alternative Statusanzeigen umfassen blinkende Leuchtmittel oder numerische Anzeigen von Messergebnissen.

Ferner kann die Fehlerstromschutzvorrichtung eine Schnittstelle aufweisen, mit der Daten bezüglich des Messergebnisses der zweiten Erfassungsschaltung aus dem Gehäuse nach außen übertragbar sind. Dies hat den Vorteil, dass die Messdaten nicht nur aufgezeichnet, sondern auch für eine weitere Datenauswertung verwendet werden können. Insbesondere können damit auch weitere Steuerungen von Anlagen beeinflusst werden.

Günstigerweise ist die zweite Impedanzschaltung dazu ausgebildet, eine Impedanz an der Auslöseeinrichtung zu messen und ein Signal in Abhängigkeit von dem Messergebnis auszugeben. Dies bedeutet, dass die zweite Erfassungsschaltung nicht nur zur Überwachung des Summenstromwandlers, sondern auch zur Überwachung der Auslöseeinrichtung dienen kann. Somit lässt sich sowohl beim Summenstromwandler als auch bei der Auslöseeinrichtung ein Drahtbruch auf einfache Weise detektieren.

Zur weiteren Vereinfachung der Fehlerstromschutzvorrichtung kann das Netzteil der zweiten Erfassungsschaltung einphasig sein. Mit einem derart einfachen Netzteil können insbesondere die Kosten von mehrphasigen Fehlerstromschutzvorrichtungen reduziert werden. Wenn dann auch noch gleichzeitig eine einfache Schwellwertfunktion zur Gleichstromerkennung genutzt wird, kann eine sehr kostengünstige Fehlerstromschutzvorrichtung bereitgestellt werden, die allstromsensitiv ist.

Die vorliegende Erfindung wird nun anhand der beigefügten Zeichnungen näher erläutert, in denen zeigen:
- FIG 1: ein Prinzipschaltbild eines netzspannungsunabhängigen Fehlerstromschutzschalters mit Wechselstromerfassung gemäß dem Stand der Technik;
- FIG 2: ein Prinzipschaltbild eines netzspannungsabhängigen Fehlerstromschutzschalters mit Gleich- und Wechselstromerfassung gemäß dem Stand der Technik; und
- FIG 3: ein Prinzipschaltbild einer erfindungsgemäßen Fehlerstromschutzvorrichtung zur Gleichstrom- und Wechselstromerfassung mit vereinfachtem Aufbau.

Die nachfolgend näher geschilderten Ausführungsbeispiele stellen bevorzugte Ausführungsformen der vorliegenden Erfindung dar. Dabei ist zu beachten, dass die geschilderten Merkmale auch in anderen Kombinationen oder auch in Alleinstellung verwendet werden können, sofern dies technisch möglich und nicht anders angegeben ist.

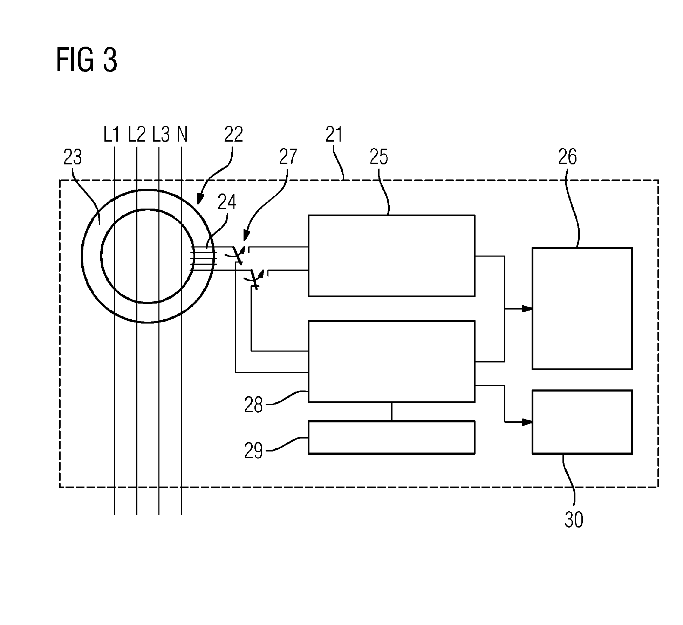

Die in FIG 3 beispielhaft dargestellte Fehlerstromschutzvorrichtung besitzt ein Gehäuse 21, in das die nachfolgenden Elektronikkomponenten eingebaut sind. Insbesondere befindet sich in dem Gehäuse 21 ein einziger Summenstromwandler 22. Dieser besitzt einen ringförmigen Wandlerkern 23, durch den Stromleitungen L1, L2, L3 und N hindurchgeführt sind. Bei diesen Leitungen handelt es sich hier um ein Dreiphasensystem mit den Phasenleitungen L1, L2 und L3 sowie der Nullleitung N. Alternativ kann es sich natürlich auch um ein Einphasensystem mit nur zwei Leitungen oder um jedes andere Mehrphasensystem handeln.

Die Stromleitungen L1, L2, L3 und N stellen die Primärseite des Summenstromwandlers 22 dar. Die Sekundärseite des Summenstromwandlers 22 bildet eine Spule 24, die an einer Seite um den ringförmigen Kern gewickelt ist. Der Summenstromwandler 22 bildet die vektorielle Summe der Ströme in den Stromleitungen L1, L2, L3 und N und gibt sekundärseitig einen entsprechenden Summenbetrag aus.

An die sekundärseitige Spule 24 des Summenstromwandlers 22 ist eine netzspannungsunabhängige erste Erfassungsschaltung angekoppelt, mit der Wechselströme detektierbar sind. Besitzt also der Summenstrom, der von der Spule 24 geliefert wird, eine Wechselstromkomponente, so wird sie von dieser ersten Erfassungsschaltung 25 erfasst. Da Wechselstromkomponenten über den Summenstromwandler transformatorisch übertragen werden, braucht die erste Erfassungsschaltung 25 kein Netzteil zur Spannungsversorgung. Überschreitet die gesamte Wechselstromkomponente oder eine spektrale Komponente davon eine vorgegebenen Bemessungsstromgrenze, so erzeugt sie ein korrespondierendes Auslösesignal, welches an eine Auslöseeinrichtung 26 übertragen wird.

Die Auslösseinrichtung 26 kann insbesondere einen Haltemagneten aufweisen, welcher Teil eines Relais ist. Ein solches Relais ist dann üblicherweise dazu ausgebildet, die Stromleitungen L1, L2, L3 und N im Auslösefall zu unterbrechen. Dies ist in FIG 3 nicht näher eingezeichnet.

Eine Umschalteinrichtung 27 ermöglicht, dass anstelle der ersten Erfassungsschaltung 25 eine zweite Erfassungsschaltung 28 an die sekundärseitige Spule 24 des einzigen Summenstromwandlers 22 angeschaltet wird. Diese zweite Erfassungsschaltung 28 ist im Gegensatz zur ersten Erfassungsschaltung 25 netzspannungsabhängig. Dies bedeutet, dass die zweite Erfassungsschaltung 28 ein separates, ebenfalls in das Gehäuse 21 eingebautes Netzteil 29 besitzt. Dieses Netzteil versorgt die Elektronik der zweiten Erfassungsschaltung 28. Das Netzteil 29 gewinnt seine Energie von den Stromleitungen L1, L2, L3 und N, auch wenn dies in FIG 3 nicht explizit eingezeichnet ist. Alternativ handelt es sich um ein einphasiges Netzteil, welches lediglich von einer einzigen Phasenleitung Energie abgreift.

Die zweite Erfassungsschaltung 28 benötigt diese Energie, um zur Gleichstromerfassung die Spule 24 zu erregen. Im Fall der Sättigung des Wandlermagneten 23 aufgrund einer hohen Gleichstromkomponente im Summenstrom ist die Impedanz der Spule 24 unabhängig von der Erregungsfrequenz. Dies ist für die zweite Erfassungsschaltung ein Indiz dafür, dass im Summenstrom eine große Gleichstromkomponente enthalten ist und die Fehlerstromschutzvorrichtung daher ausgelöst werden muss. Dementsprechend steuert die zweite Erfassungsschaltung 28 die Auslöseeinrichtung 26 unabhängig von der ersten Erfassungsschaltung 25 an.

Optional kann in dem Gehäuse 21 auch eine Schnittstelle 30 vorgesehen sein, mit der Daten von der zweiten Erfassungsschaltung 28 nach außen geführt werden können. Bei der Schnittstelle kann es sich um einen Kabelanschluss oder um ein kabelloses Interface (z. B. für WLAN oder Bluetooth) handeln. Über diese Schnittstelle 30 können aktuelle Daten bezüglich der Messungen der zweiten Erfassungsschaltung 28 oder auch einfache Zustandsdaten (z. B. Auslösesignal "0" oder "1") zur externen Weiterverarbeitung bereitgestellt werden. Eine solche Schnittstelle 30 kann auch zur Busankopplung dienen.

Alternativ oder zusätzlich zu der Schnittstelle kann eine Statusanzeige an dem Gehäuse 21 vorgesehen sein. Dadurch kann auch der Status der zweiten Erfassungsschaltung 28 und gegebenenfalls auch der der ersten Erfassungsschaltung 25 angezeigt werden. Handelt es sich bei der Statusanzeige beispielsweise um eine einfache LED, so könnten verschiedene Blinkmodi zur Unterscheidung der Fehlerströme herangezogen werden.

Bei dem obigen Ausführungsbeispiel erfolgte also eine Erweiterung eines netzspannungsunabhängigen Fehlerstromschutzschalters (FI) um einen aktiven Teil (DI). Somit kann ein Highend-FI geschaffen werden, der zugleich einen Lowend-and-Lowcost-Typ B darstellt, ohne dabei die Normen Typ B zu erfüllen. Der DI-Teil erfasst vorzugsweise nur das Sättigungsverhalten aufgrund von DC-Fehlerströmen.

Die oben geschilderte Fehlerstromschutzvorrichtung kann also in ihrem Aufbau so zusammengefasst werden, dass der netzspannungsabhängige Teil (FI) herkömmlichen A, F, G, K oder S-Typen entspricht. Der netzspannungsabhängige Teil (DI) beinhaltet ein (einphasiges) Netzteil und verwendet den Summenstromwandler vom FI-Teil mit (Einwandler-Lösung). Vorteilhafterweise wird der DI-Teil nur mit einer einfachen, kostengünstigen DC-Erkennung ausgestattet, welche nur eine Schwellwertfunktion besitzt, um die Sättigung (FI-Funktionsversagen) zu erkennen. Gegebenenfalls sind noch Statusanzeigefunktionen und Schnittstellenfunktionen integriert.

Durch die Erfindung ergibt sich also ein Highend-FI mit Zusatzfunktionen zur Überwachung. Es lässt sich somit eine Erhöhung der Sicherheit von Fehlerstromschutzvorrichtungen erzielen, da insbesondere Drahtbrüche (schadhafte Lötungen) am Wandler oder Haltemagnet oder auch FI-Fehlversagen in Folge von DC-Überlagerungen (Wandlersättigung) erkannt werden können. Ein weiterer Vorteil der Gleichfehlerstromerkennung liegt darin, dass eine Überlastung im Prüfstromkreis vermieden werden kann, da ein üblicherweise im Prüfstromkreis kleindimensionierter Widerstand nicht dauerhaft mit einem hohen Gleichstrom belastet wird.

Weitere Vorteile für einen Anwender bieten eine Anzeige, dass ein Gerät wegen einer Ausfallerkennung ausgetauscht werden muss, oder eine Anzeige, dass eine Installation auf DC-Fehler überprüft werden sollte. Darüber hinaus kann eine solche Anzeige auch dafür eingesetzt werden, dass bei DC-Fehlerströmen auf einen FI Typ B aufgerüstet werden sollte.

### Bezugszeichenliste

- 1: Summenstromwandler
- 2: Primärseite
- 3: Wandlerkern
- 4: Sekundärseite
- 5: Erfassungsschaltung
- 6: Auslöseeinrichtung
- 11: Summenstromwandler
- 12: Primärseite
- 13: Wandlerkern
- 14: Sekundärseite
- 15: Erfassungsschaltung
- 21: Gehäuse
- 22: Summenstromwandler
- 23: Wandlerkern
- 24: Spule
- 25: Erfassungsschaltung
- 26: Auslöseeinrichtung
- 27: Umschalteinrichtung
- 28: Erfassungsschaltung
- 29: Netzteil
- 30: Schnittstelle
- L1, L2, L3: Phasenleitung
- N: Nullleiter

## Patentansprüche

1. Fehlerstromschutzvorrichtung zum Überwachen eines Netzes mit
- einem Gehäuse (21),
- einem einzigen Summenstromwandler (22) in dem Gehäuse (21) zur Lieferung eines Summenstroms von dem Netz,
- einer netzspannungsunabhängigen ersten Erfassungsschaltung (25), die in das Gehäuse (21) eingebaut ist, zur Erfassung des Summenstroms und
- einer Auslöseeinrichtung (26), die ebenfalls in das Gehäuse (21) eingebaut und von der ersten Erfassungsschaltung (25) angesteuert ist,
**dadurch gekennzeichnet, dass**
- eine in das Gehäuse (21) eingebaute, netzspannungsabhängige, zweite Erfassungsschaltung (28) an den Summenstromwandler (22) angeschlossen ist,
- die zweite Erfassungsschaltung (28) von einem in das Gehäuse (21) eingebauten Netzteil mit Energie versorgbar ist,
- die zweite Erfassungsschaltung (28) dazu ausgebildet ist, eine Impedanz an einer Sekundärspule (24) des Summenstromwandlers (22) zu messen und die Auslöseeinrichtung (26) in Abhängigkeit von dem Messergebnis anzusteuern, und
- eine Umschalteinrichtung (27) in dem Gehäuse (21) dazu ausgebildet ist, die beiden Erfassungsschaltungen (25, 28) wechselweise an den Summenstromwandler (22) zu schalten.

2. Fehlerstromschutzvorrichtung nach Anspruch 1, wobei die erste Erfassungsschaltung (25) ausschließlich zur Erfassung von Wechselstromkomponenten des Summenstroms ausgebildet ist.

3. Fehlerstromschutzvorrichtung nach Anspruch 1 oder 2, wobei die zweite Erfassungsschaltung (28) zur Erfassung von Gleichstromkomponenten und Wechselstromkomponenten des Summenstroms ausgebildet ist.

4. Fehlerstromschutzvorrichtung nach Anspruch 1 oder 2, wobei die zweite Erfassungsschaltung (28) ausschließlich zur Erfassung von Gleichstromkomponenten des Summenstroms ausgebildet ist.

5. Fehlerstromschutzvorrichtung nach Anspruch 4, wobei die zweite Erfassungsschaltung (28) dazu ausgebildet ist, aus einer erfassten Gleichstromkomponente allein durch eine Schwellwertfunktion ein Ansteuersignal für die Auslöseeinrichtung (26) zu erzeugen.

6. Fehlerstromschutzvorrichtung nach einem der vorhergehenden Ansprüche, die eine Statusanzeige aufweist, mit der ein Repräsentant des Messergebnisses der zweiten Erfassungsschaltung (28) anzeigbar ist.

7. Fehlerstromschutzvorrichtung nach einem der vorhergehenden Ansprüche, die eine Schnittstelle (30) aufweist, mit der Daten bezüglich des Messergebnisses der zweiten Erfassungsschaltung (28) aus dem Gehäuse nach außen übertragbar sind.

8. Fehlerstromschutzvorrichtung nach einem der vorhergehenden Ansprüche, wobei die zweite Erfassungsschaltung (28) dazu ausgebildet ist, eine Impedanz an der Auslöseeinrichtung (26) zu messen und ein Signal in Abhängigkeit von dem Messergebnis auszugeben.

9. Fehlerstromschutzvorrichtung nach einem der vorhergehenden Ansprüche, wobei das Netzteil der zweiten Erfassungsschaltung (28) einphasig ist.
